# EUROPEAN PATENT APPLICATION

(11) **EP 4 733 125 A2**
(43) Date of publication of application: **29.04.2026**
(21) Application number: 25204429.2
(22) Date of filing: 24.09.2025
(51) Int. Cl.: B60L 53/10, B60L 53/22, B60L 53/66, H02J 7/02

(54) **CHARGING DEVICE FOR VEHICLE**

(30) Priority: 25.10.2024 JP 2024188251
(71) Applicant: TOYOTA JIDOSHA KABUSHIKI KAISHA, Toyota-shi, Aichi-ken 471-8571 (JP)
(72) Inventor: ASABA, Kotaro, 471-8571 Toyota-shi, Aichi-ken (JP)
(74) Representative: Cabinet Beau de Loménie

(57) **Abstract**

A charging inlet (50) is shared by an alternating-current charging connector (530) and a direct-current charging connector (630). A drive circuit (75) connects a DC charging relay (DCR) when a Hi signal is inputted from an AND circuit (74), and cuts off the DC charging relay (DCR) when a Lo signal is inputted. When a Hi signal is inputted from a NOT circuit (73) and a Hi signal is inputted from a controller (76) to the AND circuit (74), the AND circuit (74) outputs the Hi signal. An alternating-current voltage applied to a power input terminal (P1, P2) of the charging inlet (50) passes through a filter (71) of a control circuit (70) and is rectified by a rectifier circuit (72), and a Hi signal is outputted to the NOT circuit (73). The NOT circuit (73) inverts the Hi signal to a Lo signal and outputs the Lo signal to the AND circuit (74).

## Description

### CROSS REFERENCE TO RELATED APPLICATIONS

This application is based on Japanese Patent Application No. 2024-188251 filed on October 25, 2024 with the Japan Patent Office, the entire contents of which are hereby incorporated by reference.

### BACKGROUND

### Field

The present disclosure relates to a charging device for a vehicle.

### Description of the Background Art

Japanese Patent Laying-Open No. 2013-230022 discloses an electrically powered vehicle that is connectable to a direct-current power supply outside the vehicle and an alternating-current power supply outside the vehicle. Hereinafter, alternating current may be referred to as "AC", and direct current may be referred to as "DC".
The electrically powered vehicle disclosed in the above publication includes a DC inlet to which a DC charging connector is connectable, and an AC inlet to which an AC charging connector is connectable. When the DC charging connector is connected to the DC inlet, a relay disposed between the DC inlet and a battery (a DC charging relay) is connected, and a relay disposed between the AC inlet and the battery (an AC charging relay) is cut off, so that charging by the DC power supply (DC charging) can be performed. When the AC charging connector is connected to the AC inlet, the DC charging relay is cut off and the AC charging relay is connected, so that charging by the AC power supply (AC charging) can be performed.

In the electrically powered vehicle described in the above publication, different charging connectors and inlets are used for DC charging and AC charging. Accordingly, even if the DC charging relay erroneously enters a connected state during AC charging, a voltage (direct-current power) of the battery is applied to the DC inlet, but the voltage of the battery is not applied to a charging system of the AC power supply.

In an electrically powered vehicle that shares an inlet for DC charging and AC charging, if a DC charging relay erroneously enters a connected state during AC charging, a voltage (direct-current power) of a battery may be applied to a charging system of an AC power supply. When the voltage of the battery is applied to the charging system of the AC power supply, the charging system may fail.

### SUMMARY

An object of the present disclosure is to suppress a DC charging relay from entering a connected state during AC charging, in a vehicle that shares an inlet for DC charging and AC charging.

A charging device for a vehicle of the present disclosure includes a charging inlet, a direct-current charging system, an alternating-current charging system, and a control circuit. The charging inlet is shared by a direct-current charging connector and an alternating-current charging connector. The direct-current charging system is electrically connected to a power input terminal of the charging inlet via a DC charging relay, to supply direct-current power supplied from the direct-current charging connector to a battery. The alternating-current charging system is electrically connected to the power input terminal via an AC charging relay, to convert alternating-current power supplied from the alternating-current charging connector into direct-current power and supply the direct-current power to the battery. The control circuit controls opening and closing of the DC charging relay. When the alternating-current power is supplied to the power input terminal, the control circuit prohibits connection of the DC charging relay.

With this configuration, DC charging can be performed by the direct-current charging system, and AC charging can be performed by the alternating-current charging system. The control circuit controls opening and closing of the DC charging relay. When the alternating-current power is supplied to the power input terminal, the control circuit prohibits connection of the DC charging relay.

When the alternating-current power is supplied to the power input terminal, connection of the DC charging relay is prohibited. Therefore, with the charging device, it is possible to suppress the DC charging relay from entering a connected state during AC charging.

In the charging device described above, a shared power line may be connected to the power input terminal. The direct-current charging system may include a direct-current power line connected to the shared power line, and the alternating-current charging system may include an alternating-current power line connected to the shared power line. In addition, when power flowing through the shared power line is alternating-current power, the control circuit may prohibit connection of the DC charging relay.

With this configuration, the direct-current power line and the alternating-current power line branch from the shared power line connected to the power input terminal of the charging inlet, and power is supplied to the battery. When the power flowing through the shared power line is alternating-current power, the control circuit prohibits connection of the DC charging relay, and thus it is possible to suppress the DC charging relay from entering the connected state during AC charging.

The control circuit may include a filter, a rectifier circuit, a NOT circuit, an AND circuit, and a drive circuit. The filter allows, when an alternating-current voltage is applied to the power input terminal, the alternating-current voltage having a predetermined frequency or higher to pass therethrough, or the alternating-current voltage in a set frequency band to pass therethrough. The rectifier circuit rectifies the alternating-current voltage outputted from the filter, and outputs a direct-current voltage. The NOT circuit inverts a voltage signal. To the AND circuit, an output signal of the NOT circuit and a control signal for the DC charging relay are inputted. The drive circuit drives the DC charging relay based on an output signal of the AND circuit.

With this configuration, the control circuit is constituted by a circuit capable of ensuring reliability even at a relatively high voltage, such as the filter and the rectifier circuit, and a logic circuit. Therefore, the control circuit can be constituted without using a high-performance microcomputer capable of detecting an alternating-current voltage (alternating-current power) while ensuring reliability.

The control signal for the DC charging relay may be a high-level signal when the DC charging relay is connected, and may be a low-level signal when the DC charging relay is cut off. In addition, when a high-level signal is inputted to the drive circuit, the drive circuit may set the DC charging relay to a connected state.

With this configuration, when the alternating-current voltage (alternating-current power) is applied to the power input terminal, and the frequency of the alternating-current voltage is equal to or higher than the predetermined frequency or is in the set frequency band, the alternating-current voltage passes through the filter and is inputted to the rectifier circuit. The rectifier circuit rectifies the inputted alternating-current voltage into a direct-current voltage. The direct-current voltage outputted from the rectifier circuit is inputted, as a high-level voltage signal (high-level signal), to the NOT circuit. In the NOT circuit, the high-level signal is inverted to a low-level signal and inputted to the AND circuit.

When the alternating-current voltage is applied to the power input terminal, the low-level signal is inputted from the NOT circuit to the AND circuit. Accordingly, when the alternating-current power is supplied to the power input terminal, even if the control signal for the DC charging relay is the high-level signal, a low-level signal is outputted from the AND circuit, and connection of the DC charging relay is prohibited.

On the other hand, when a direct-current voltage (direct-current power) is applied to the power input terminal, the direct-current voltage is attenuated by the filter and does not pass through the filter, and the level of the voltage inputted to the rectifier circuit is approximately 0 [V]. When no power is supplied to the power input terminal, the level of the voltage inputted to the rectifier circuit is 0 [V]. In these cases, the direct-current voltage outputted from the rectifier circuit is 0 [V], and a low-level voltage signal (low-level signal) is inputted to the NOT circuit. In the NOT circuit, the low-level signal is inverted to a high-level signal and inputted to the AND circuit.

When the direct-current voltage is applied to the power input terminal, or when no power is supplied to the power input terminal, the high-level signal is inputted from the NOT circuit to the AND circuit. Accordingly, when the control signal for the DC charging relay is the high-level signal, a high-level signal is outputted from the AND circuit, and the DC charging relay is connected.

The charging device may further include a control device that controls the DC charging relay and the AC charging relay. When the direct-current charging connector is connected to the charging inlet, the control device may output a control signal for connecting the DC charging relay and cutting off the AC charging relay. When the alternating-current charging connector is connected to the charging inlet, the control device may output a control signal for cutting off the DC charging relay and connecting the AC charging relay. In addition, the control circuit may further include a controller that outputs a high-level signal to the AND circuit, upon receiving a control signal for connecting the DC charging relay.

With this configuration, when the direct-current charging connector is connected to the charging inlet, the DC charging relay enters the connected state and the AC charging relay enters a cut-off state, so that DC charging can be performed. When the alternating-current charging connector is connected to the charging inlet, the DC charging relay enters the cut-off state and the AC charging relay enters the connected state, so that AC charging can be performed.

When the controller of the control circuit receives the control signal for connecting the DC charging relay from the control device, the controller outputs the high-level signal to the AND circuit. When the direct-current charging connector is connected to the charging inlet, the output of the NOT circuit is the high-level signal. Thus, when the control signal for connecting the DC charging relay is outputted from the control device, the DC charging relay enters connected state and DC charging can be performed.

When the alternating-current charging connector is connected to the charging inlet and AC charging is performed, the alternating-current power is supplied to the power input terminal, and thus the output of the NOT circuit is the low-level signal. Even when the control signal for connecting the DC charging relay or the like is outputted and the high-level signal is outputted from the controller due to a malfunction or the like, the output of the NOT circuit is the low-level signal, the high-level signal is not outputted from the AND circuit, and the DC charging relay does not enter the connected state.

The foregoing and other objects, features, aspects and advantages of the present disclosure will become more apparent from the following detailed description of the present disclosure when taken in conjunction with the accompanying drawings.

### BRIEF DESCRIPTION OF THE DRAWINGS

Fig. 1 is a schematic overall configuration diagram of a vehicle equipped with a charging device according to the present embodiment.
Fig. 2 is a diagram illustrating an output signal of a NOT circuit in a control circuit.
Fig. 3 is a diagram illustrating an output signal of an AND circuit in the control circuit.

### DESCRIPTION OF THE PREFERRED EMBODIMENTS

Hereinafter, an embodiment of the present disclosure will be described in detail with reference to the drawings. It should be noted that the same or corresponding parts in the drawings will be designated by the same reference numerals, and the description thereof will not be repeated.

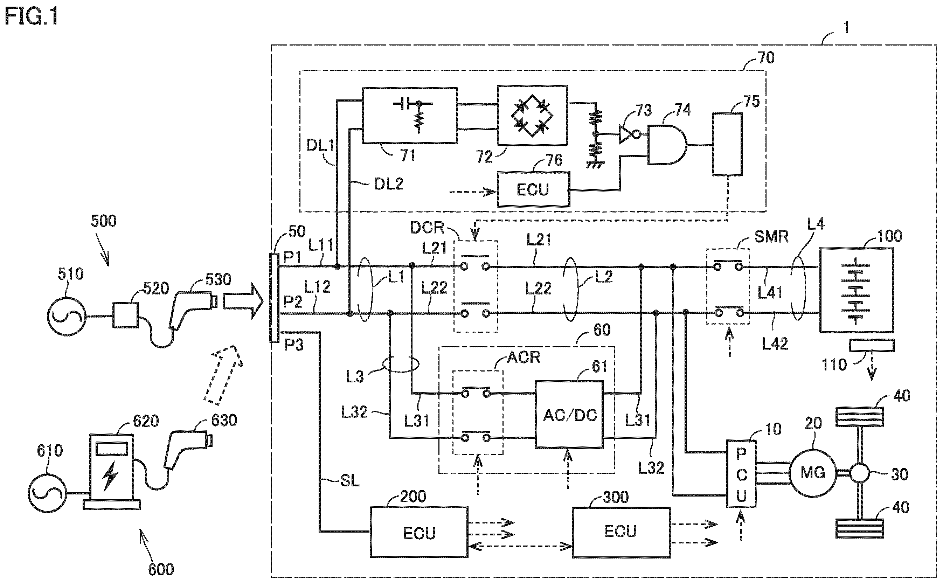

Fig. 1 is a schematic overall configuration diagram of a vehicle 1 equipped with a charging device according to the present embodiment. Vehicle 1 according to the present embodiment is a battery electric vehicle (BEV) that does not include an engine (internal combustion engine). Vehicle 1 may be a plug-in hybrid electric vehicle (PHEV) including an engine. Vehicle 1 includes a power control unit (PCU) 10, a motor generator (MG) 20 which is a rotary electric machine, a motive power transmission gear 30, drive wheels 40, a system main relay SMR, a battery 100, a monitoring module 110, a charging electronic control unit (ECU) 200, and a control ECU 300. Charging ECU 200 and control ECU 300 correspond to an example of the "control device" of the present disclosure.

MG 20 is, for example, an interior permanent magnet synchronous motor (IPM motor), and has a function as an electric motor (motor) and a function as a power generator (generator). An output torque of MG 20 is transmitted to drive wheels 40 via motive power transmission gear 30 configured to include a reduction gear, a differential gear, and the like.

During braking of vehicle 1, MG 20 is driven by drive wheels 40, and MG 20 operates as a power generator. Thereby, MG 20 also functions as a braking device that performs regenerative braking for converting kinetic energy of vehicle 1 into electric power. Regenerative power generated by a regenerative braking force in MG 20 is stored in battery 100.

PCU 10 is a power conversion device that bidirectionally converts power between MG 20 and battery 100. PCU 10 includes, for example, an inverter and a converter that operate based on a control signal from control ECU 300.

System main relay SMR is electrically connected to a power line connecting battery 100 and PCU 10. When system main relay SMR is connected (closed) in response to a control signal from control ECU 300, power can be transmitted and received between battery 100 and PCU 10. Further, DC charging and AC charging described below can be performed. On the other hand, when system main relay SMR is cut off (opened) in response to a control signal from control ECU 300, electrical connection between battery 100 and PCU 10 is cut off.

Battery 100 stores power for driving MG 20. Battery 100 is a rechargeable direct-current power supply (secondary battery), and is a battery assembly including a plurality of unit cells (battery cells) electrically connected in series. Each unit cell may be a lithium ion battery, for example.

Monitoring module 110 senses a voltage VB of battery 100, a temperature TB of battery 100, and a current IB inputted to or outputted from battery 100. Then, monitoring module 110 calculates a state of charge (SOC) of battery 100. Information such as voltage VB and the SOC is outputted to charging ECU 200 and control ECU 300.

Vehicle 1 includes a charging inlet 50, and battery 100 can be externally charged. An alternating-current charging connector 530 and a direct-current charging connector 630 are connectable to charging inlet 50. Charging inlet 50 is shared by alternating-current charging connector 530 and direct-current charging connector 630.

An AC charging facility 500 supplies alternating-current power (AC power) supplied from a power system (commercial power supply) 510 to vehicle 1 via alternating-current charging connector 530. The power supplied from alternating-current charging connector 530 may be AC power having a frequency of 50 to 60 [Hz] and a voltage of 100 to 240 [V], for example. In AC charging facility 500, a charging cable is provided with a CPLT circuit 520. It should be noted that AC charging facility 500 may be configured such that CPLT circuit 520 is provided inside a charging station, or may be configured such that a charging cable that does not include CPLT circuit 520 is connected to a household outlet, for example.

A DC charging facility 600 includes a quick charger 620 that converts alternating-current power (AC power) of a power system (commercial power supply) 610 into direct-current power (DC power). The DC power outputted from quick charger 620 is supplied to vehicle 1 via direct-current charging connector 630. Quick charger 620 is provided with a charging power control circuit that controls a voltage, a current, an upper limit current (upper limit power), and the like of the DC power to be outputted.

Charging inlet 50 has power input terminals P1 and P2. Power input terminals P1 and P2 are terminals to which the powers are supplied from alternating-current charging connector 530 and direct-current charging connector 630. For example, in the case of the AC power, power input terminals P1 and P2 may be a Hot terminal and a Cold terminal. In the case of the DC power, power input terminals P1 and P2 may be a positive terminal and a negative terminal. Charging inlet 50 further has a signal terminal P3. Signal terminal P3 is a terminal for transmitting and receiving a Proximity signal (PISW signal), a control pilot (CPLT) signal, a controller area network (CAN) signal, or the like between charging ECU 200 and each of alternating-current charging connector 530 and direct-current charging connector 630. Although one signal terminal P3 is provided in Fig. 1, two signal terminals may be provided when transmission and reception of signals are performed using a PISW signal and a CPLT signal.

A power line L11 is connected to power input terminal P1, and a power line L12 is connected to power input terminal P2. Power line L11 and power line L12 are also collectively referred to as a power line L1. Power line L1 (power lines L11 and L12) corresponds to an example of the "shared power line" of the present disclosure.

Power line L11 is connected to a power line L21, and power line L12 is connected to a power line L22. Power lines L21 and L22 are also collectively referred to as a power line L2. Power line L2 (power lines L21 and L22) is provided with a DC charging relay DCR. Opening and closing of DC charging relay DCR is controlled by a control circuit 70 described later. When DC charging relay DCR is closed, conduction of power line L2 is connected. When DC charging relay DCR is opened, conduction of power line L2 is cut off. Power line L2 (power lines L21 and L22) corresponds to an example of the "direct-current power line" of the present disclosure.

Power line L21 is connected to a power line L41 via system main relay SMR, and power line L22 is connected to a power line L42 via system main relay SMR. Power line L41 may be a positive electrode line of battery 100, and power line L42 may be a negative electrode line of the battery. Power lines L41 and L42 are also collectively referred to as a power line L4.

When direct-current charging connector 630 is connected to charging inlet 50, and DC charging relay DCR and system main relay SMR enter a connected state, battery 100 can be charged (DC charged) using the DC power supplied from DC charging facility 600. Power lines L1 and L2 and DC charging relay DCR correspond to an example of the "direct-current charging system" of the present disclosure.

Power line L11 is connected to a power line L31, and power line L12 is connected to a power line L32. Power lines L31 and L32 are also collectively referred to as a power line L3. In an in-vehicle charger 60, power line L3 is connected to an AC/DC converter 61 via an AC charging relay ACR. AC/DC converter 61 is a power converter that converts AC power into DC power. The DC power outputted from AC/DC converter 61 flows through power line L3 and is supplied to power line L4 via system main relay SMR.

When alternating-current charging connector 530 is connected to charging inlet 50, and AC charging relay ACR and system main relay SMR enter the connected state, the AC power supplied from AC charging facility 500 is converted into DC power by in-vehicle charger 60 (AC/DC converter 61), and battery 100 can be charged (AC charged). Power lines L1 and L3 and in-vehicle charger 60 (AC charging relay ACR, AC/DC converter 61) correspond to an example of the "alternating-current charging system" of the present disclosure.

Control ECU 300 includes a central processing unit (CPU) and a memory. Control ECU 300 controls each device such as PCU 10, based on signals received from monitoring module 110 and charging ECU 200, signals from various sensors (not shown) (for example, an accelerator opening degree signal, a vehicle speed signal, and the like), and information such as a map and a program stored in the memory, to control traveling of vehicle 1. It should be noted that communication with the monitoring module and communication between the ECUs may be performed by CAN communication, for example.

Charging ECU 200 includes a CPU and a memory. Charging ECU 200 controls charging of battery 100, using a signal received from monitoring module 110, information of a charging facility received through a signal line SL connected to signal terminal P3 of charging inlet 50, and the like.

Signal line SL transmits a signal between alternating-current charging connector 530 (AC charging facility 500) or direct-current charging connector 630 (DC charging facility 600) and charging ECU 200. For example, in a case where AC charging facility 500 is of a PISW type (in a case where CPLT circuit 520 is not included), when alternating-current charging connector 530 is connected to charging inlet 50, a PISW signal is transmitted to charging ECU 200 through signal line SL. Charging ECU 200 senses that alternating-current charging connector 530 is connected to charging inlet 50, based on a potential or a change in the potential of the received PISW signal. Charging ECU 200 senses a voltage and a maximum current of the power outputted from AC charging facility 500, based on the PISW signal.

For example, in a case where AC charging facility 500 is of a CPLT type, a PISW signal is transmitted to charging ECU 200 through signal line SL. Charging ECU 200 senses that alternating-current charging connector 530 is connected to charging inlet 50, based on the received PISW signal. Then, charging ECU 200 requests CPLT circuit 520 to transmit a CPLT signal (pulse width modulation (PWM) signal), and senses a voltage and a maximum current of the power outputted from AC charging facility 500 based on the PWM signal received from CPLT circuit 520. It should be noted that, in this case, charging inlet 50 may be provided with two signal terminals for the PISW signal and the CPLT signal, and may also be provided with two signal lines SL.

When charging ECU 200 senses that alternating-current charging connector 530 is connected to charging inlet 50 based on the signal inputted through signal line SL, charging ECU 200 cuts off DC charging relay DCR, connects AC charging relay ACR, and connects system main relay SMR. Then, charging ECU 200 controls AC/DC converter 61 based on information such as the voltage and the maximum current from AC charging facility 500 and the SOC of battery 100, to perform charging (AC charging) of battery 100.

When direct-current charging connector 630 is connected to charging inlet 50, a PISW signal is transmitted to charging ECU 200 through signal line SL. Charging ECU 200 senses that direct-current charging connector 630 is connected to charging inlet 50, based on the received PISW signal. Then, charging ECU 200 requests quick charger 620 to transmit a CPLT signal, and senses a voltage and a maximum current of the power outputted from DC charging facility 600 based on the CPLT signal received from quick charger 620. In this case, charging inlet 50 is provided with two signal terminals for the PISW signal and the CPLT signal, and is also provided with two signal lines SL.

When charging ECU 200 senses that direct-current charging connector 630 is connected to charging inlet 50 based on the signal inputted through signal line SL, charging ECU 200 connects DC charging relay DCR, cuts off AC charging relay ACR, and connects system main relay SMR. Thereby, charging (DC charging) of battery 100 is performed using the power supplied from DC charging facility 600. When communication of the CPLT signal is established, charging ECU 200 performs high level communication (HLC) with quick charger 620, to control a current and the like outputted from DC charging facility 600 (quick charger 620). It should be noted that charging control may be performed by CAN communication.

If DC charging relay DCR is erroneously connected for some reason during AC charging by AC charging facility 500, the voltage (direct-current power) of battery 100 is applied to in-vehicle charger 60 (AC/DC converter 61) through power line L3. When the voltage of battery 100 is applied to in-vehicle charger 60, in-vehicle charger 60 may fail.

In the present embodiment, erroneous connection of DC charging relay DCR during AC charging is suppressed by providing control circuit 70. Control circuit 70 includes a filter 71, a rectifier circuit 72, a NOT circuit 73, an AND circuit 74, and a drive circuit 75. Control circuit 70 controls opening and closing of DC charging relay DCR.

Filter 71 is connected to power line L1 (power lines L11 and L12) by input lines DL1 and DL2, and a voltage applied to power input terminals P1 and P2 is inputted to filter 71. Filter 71 is constituted by a high-pass filter or a band-pass filter. When filter 71 is a high-pass filter, it may be a high-pass filter that allows a frequency of 40 [Hz] or more to pass therethrough (may be a high-pass filter having a cut-off frequency of 40 [Hz]), for example. When filter 71 is a band-pass filter, it may be a band-pass filter that allows a frequency band of 40 to 70 [Hz] to pass therethrough, for example. Filter 71 may be a passive filter including an RC circuit, an RLC circuit, or the like, or may be an active filter including an active element.

When the voltage applied to power input terminals P1 and P2 (voltage applied to power lines L11 and L12) is an alternating-current voltage having a frequency of 50 to 60 [Hz] outputted from AC charging facility 500, filter 71 outputs the alternating-current voltage. When the voltage applied to power input terminals P1 and P2 (voltage applied to power lines L11 and L12) is a direct-current voltage, an output voltage from filter 71 is 0 [V]. Further, when no voltage is applied to power input terminals P1 and P2 (power lines L11 and L12), the output voltage from filter 71 is 0 [V].

Rectifier circuit 72 rectifies the alternating-current voltage outputted from filter 71, and outputs a direct-current voltage. Rectifier circuit 72 may be a full-wave rectifier circuit using a diode and a thyristor, or may be a half-wave rectifier circuit, for example. When the alternating-current voltage is inputted from filter 71, rectifier circuit 72 outputs the direct-current voltage corresponding to the alternating-current voltage. When the output voltage of filter 71 is 0 [V], an output voltage of rectifier circuit 72 is also 0 [V].

The direct-current voltage outputted from rectifier circuit 72 is stepped down to a voltage corresponding to a high-level signal of AND circuit 74 by resistance voltage division or the like, and is outputted to NOT circuit 73. For example, when a voltage of 3.0 to 5.0 [V] is a high-level signal (Hi signal) and a voltage of 0 to 1.5 [V] is a low-level signal (Lo signal) in AND circuit 74, the direct-current voltage outputted from rectifier circuit 72 is stepped down to 3.0 to 5.0 [V], and is outputted as a Hi signal to NOT circuit 73. When the output voltage of filter 71 is 0 [V], rectifier circuit 72 outputs a Lo signal to NOT circuit 73.

When the Hi signal is inputted to NOT circuit 73, NOT circuit 73 inverts the Hi signal and outputs a Lo signal to AND circuit 74. When the Lo signal is inputted to NOT circuit 73, NOT circuit 73 outputs a Hi signal to AND circuit 74.

When a controller 76 receives a control signal for connecting DC charging relay DCR from charging ECU 200, controller 76 outputs a Hi signal to AND circuit 74. When controller 76 receives a control signal for cutting off the DC charging relay from charging ECU 200, controller 76 outputs a Lo signal to AND circuit 74.

When the signal inputted from NOT circuit 73 is the Hi signal and the signal inputted from controller 76 is the Hi signal, AND circuit 74 outputs a Hi signal to drive circuit 75. When one of the signal inputted from NOT circuit 73 and the signal inputted from controller 76 is the Lo signal, or when both of the signals are the Lo signals, AND circuit 74 outputs a Lo signal to drive circuit 75.

When drive circuit 75 receives the Hi signal from AND circuit 74, drive circuit 75 connects DC charging relay DCR. When drive circuit 75 receives the Lo signal from AND circuit 74, drive circuit 75 cuts off DC charging relay DCR.

In control circuit 70, when the alternating-current voltage is applied to power input terminals P1 and P2, the Lo signal is outputted from NOT circuit 73. Accordingly, in a state where the alternating-current voltage is applied to power input terminals P1 and P2, even if the Hi signal is outputted from controller 76, the Hi signal is not outputted from AND circuit 74 to drive circuit 75, and thus DC charging relay DCR is prohibited from entering the connected state.

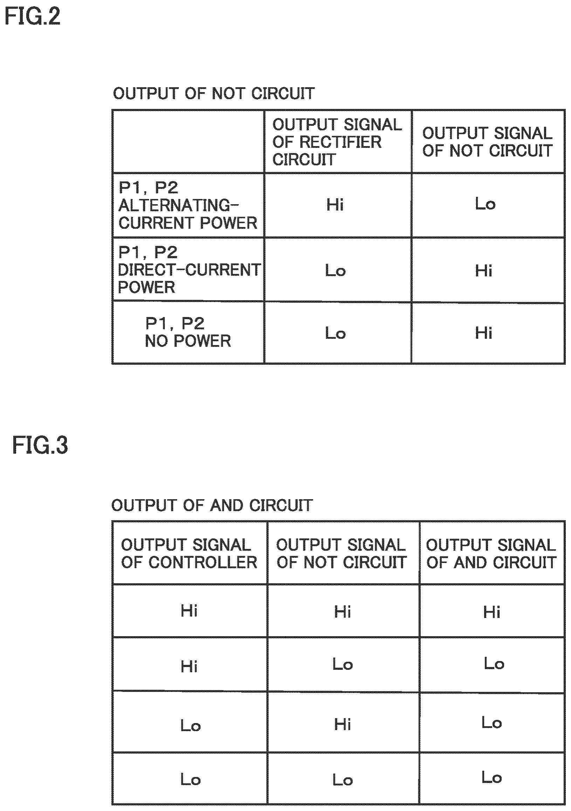

Fig. 2 is a diagram illustrating an output signal of NOT circuit 73 in control circuit 70. As shown in Fig. 2, when the alternating-current voltage is applied (when the alternating-current power is supplied) to power input terminals P1 and P2, an output signal of rectifier circuit 72 is the Hi signal, and the Lo signal is outputted from NOT circuit 73. When the direct-current power (direct-current voltage) is supplied to power input terminals P1 and P2, and when no power is supplied to power input terminals P1 and P2, the output signal of rectifier circuit 72 is the Lo signal, and the Hi signal is outputted from NOT circuit 73.

Fig. 3 is a diagram illustrating an output signal of AND circuit 74 in control circuit 70. When an output signal of controller 76 is the Hi signal and the output signal of NOT circuit 73 is the Hi signal, AND circuit 74 outputs the Hi signal. Drive circuit 75 receives the Hi signal of AND circuit 74, and connects DC charging relay DCR. When the output signal of NOT circuit 73 is the Lo signal, AND circuit 74 outputs the Lo signal, regardless of the output signal of controller 76. When the output signal of AND circuit 74 is the Lo signal, drive circuit 75 cuts off DC charging relay DCR.

According to the present embodiment, when the alternating-current voltage is applied to power input terminals P1 and P2, control circuit 70 outputs the Lo signal from NOT circuit 73. Thereby, in the state where the alternating-current voltage is applied to power input terminals P1 and P2, the Hi signal is not outputted from AND circuit 74 to drive circuit 75, and thus DC charging relay DCR is prohibited from entering the connected state. Therefore, it is possible to suppress DC charging relay DCR from entering the connected state during AC charging.

According to the present embodiment, control circuit 70 is constituted by a circuit capable of ensuring reliability even at a relatively high voltage, such as filter 71 and rectifier circuit 72, and a logic circuit such as NOT circuit 73 and AND circuit 74. Thereby, it is possible to prohibit DC charging relay DCR from entering the connected state during AC charging, without using a high-performance microcomputer capable of detecting an alternating-current voltage (alternating-current power) of 100 to 240 [V]. For example, in a case where charging ECU 200, control ECU 300, or the like detects that the alternating-current voltage is applied to power input terminals P1 and P2, and connection of DC charging relay DCR is prohibited when the alternating-current voltage is applied to power input terminals P1 and P2, it is necessary to employ a high-performance CPU or the like in order to increase reliability of charging ECU 200 and control ECU 300. In the present embodiment, since control circuit 70 is used, it is possible to prohibit DC charging relay DCR from entering the connected state during AC charging, without using a high-performance CPU or the like.

In the above embodiment, when controller 76 receives the control signal for connecting DC charging relay DCR from charging ECU 200, controller 76 outputs the Hi signal to AND circuit 74. However, controller 76 may be omitted, and a Hi signal may be inputted from charging ECU 200 to AND circuit 74 when DC charging relay DCR is connected.

The above embodiment has described an example in which a high-pass filter having a cut-off frequency of 40 [Hz] or a band-pass filter that allows a frequency band of 40 to 70 [Hz] to pass therethrough is used as filter 71. However, it is only necessary that the cut-off frequency or the passband of filter 71 is set such that filter 71 allows the AC power (alternating-current voltage) supplied from AC charging facility 500 (alternating-current charging connector 530) to pass therethrough but does not allow direct-current power (direct-current voltage) to pass therethrough.

Although the embodiment of the present disclosure has been described, it should be understood that the embodiment disclosed herein is illustrative and non-restrictive in every respect. The technical scope defined by the present disclosure is defined by the scope of the claims, and is intended to include any modifications within the scope and meaning equivalent to the scope of the claims.

## Claims

1. A charging device for a vehicle, the charging device comprising:
a charging inlet (50) configured for connection with a direct-current charging connector (630) and an alternating-current charging connector (530);
a direct-current charging system (L1, L2, DCR) electrically connected to a power input terminal (P1, P2) of the charging inlet (50) via a DC charging relay (DCR), to supply direct-current power supplied from the direct-current charging connector (630) to a battery (100);
an alternating-current charging system (L1, L3, 60) electrically connected to the power input terminal (P1, P2) via an AC charging relay (ACR), to convert alternating-current power supplied from the alternating-current charging connector (530) into direct-current power and supply the direct-current power to the battery (100); and
a control circuit (70) that controls opening and closing of the DC charging relay (DCR), wherein
the control circuit (70) is configured to prohibit connection of the DC charging relay (DCR) when the alternating-current power is supplied to the power input terminal (P1, P2),.

2. The charging device according to claim 1, wherein
a shared power line (L1) is connected to the power input terminal (P1, P2),
the direct-current charging system (L1, L2, DCR) includes a direct-current power line (L2) connected to the shared power line (L1),
the alternating-current charging system (L1, L3, 60) includes an alternating-current power line (L3) connected to the shared power line (L1), and
the control circuit (70) is configured to prohibit connection of the DC charging relay (DCR) when power flowing through the shared power line (L1) is alternating-current power.

3. The charging device according to claim 1 or 2, wherein
the control circuit (70) includes
a filter (71) configured to allow, when an alternating-current voltage is applied to the power input terminal (P1, P2), the alternating-current voltage having a predetermined frequency or higher to pass therethrough, or the alternating-current voltage in a set frequency band to pass therethrough,
a rectifier circuit (72) configured to rectify the alternating-current voltage outputted from the filter (71),
a NOT circuit (73) configured to invert a voltage signal of the rectifier circuit (72),
an AND circuit (74) configured to receive an output signal of the NOT circuit and a control signal for the DC charging relay (DCR) as inputs, and
a drive circuit (75) configured to drive the DC charging relay (DCR) based on an output signal of the AND circuit (74).

4. The charging device according to claim 3, wherein the drive circuit (75) is configured so that:
the control signal for the DC charging relay (DCR) is a high-level signal when the DC charging relay (DCR) is connected, and is a low-level signal when the DC charging relay (DCR) is cut off, and
when a high-level signal is inputted to the drive circuit (75), the drive circuit (75) sets the DC charging relay (DCR) to a connected state.

5. The charging device according to claim 4, further comprising a control device (200, 300) configured to control the DC charging relay (DCR) and the AC charging relay (ACR), wherein
the control device (200, 300) is configured to output a control signal for connecting the DC charging relay (DCR) and cutting off the AC charging relay (ACR) when the direct-current charging connector (630) is connected to the charging inlet (50),
the control device (200, 300) is configured to output a control signal for cutting off the DC charging relay (DCR) and connecting the AC charging relay (ACR) when the alternating-current charging connector (530) is connected to the charging inlet (50), , and
the control circuit (70) further includes a controller (76) configured to output a high-level signal to the AND circuit, upon receiving a control signal for connecting the DC charging relay (DCR).
